# EUROPEAN PATENT APPLICATION

(11) **EP 4 832 704 A1**
(43) Date of publication of application: **28.10.2026**
(21) Application number: 24915782.7
(22) Date of filing: 20.08.2024
(51) Int. Cl.: H10H 29/20, H10D 86/00, H10H 20/84, H10H 20/831, H10H 20/857, H10H 20/819

(54) **DISPLAY DEVICE, AND METHOD FOR MANUFACTURING DISPLAY DEVICE**

(30) Priority: 02.01.2024 KR 20240000263
(71) Applicant: Samsung Display Co., Ltd., Yongin-si, Gyeonggi-do 17113 (KR)
(72) Inventor: SO, Myeong Su, Yongin-si, Gyeonggi-do 17113 (KR); KANG, Jae Woong, Yongin-si, Gyeonggi-do 17113 (KR); JANG, Sung Ae, Yongin-si, Gyeonggi-do 17113 (KR)
(74) Representative: Walaski, Jan Filip
(86) International application number: PCT/KR2024/012328
(87) International publication number: WO 2025/146893

(57) **Abstract**

A display device includes a pixel circuit layer including a pixel circuit above a base layer, and a light-emitting element layer above the pixel circuit layer, and including a light-emitting part including a first anode electrode, a first connection electrode, a second anode electrode, first light-emitting elements above the first anode electrode, and second light-emitting elements above the second anode electrode, wherein the first light-emitting elements and the second light-emitting elements include a first semiconductor layer, a second semiconductor layer, an active layer between the first semiconductor layer and the second semiconductor layer, a first end to which the first semiconductor layer is adjacent, and a second end to which the second semiconductor layer is adjacent, and wherein the first connection electrode electrically connects the first end of the first light-emitting elements and the second anode electrode such that the first and second light-emitting elements are electrically connected in series.

## Description

### Technical Field

The disclosure relates to a display device and a method of manufacturing the display device.

### Background Art

Recently, as interest in information display is increased, research and development on a display device is continuously being conducted.

### Detailed Description of Invention

### Technical Problem

An aspect of the disclosure is to provide a display device, and a method of manufacturing the display device capable of reducing or preventing the likelihood of malfunction of a pixel (for example, a light-emitting element), thereby reducing necessity of a repair process, and improving process efficiency.

### Technical Solution

According to one or more embodiments of the disclosure, a display device may include a pixel circuit layer including a pixel circuit above a base layer, and a light-emitting element layer above the pixel circuit layer, and including a light-emitting part including a first anode electrode, a first connection electrode, a second anode electrode, first light-emitting elements above the first anode electrode, and second light-emitting elements above the second anode electrode, wherein the first light-emitting elements and the second light-emitting elements include a first semiconductor layer, a second semiconductor layer, an active layer between the first semiconductor layer and the second semiconductor layer, a first end to which the first semiconductor layer is adjacent, and a second end to which the second semiconductor layer is adjacent, and wherein the first connection electrode electrically connects the first end of the first light-emitting elements and the second anode electrode such that the first light-emitting elements and the second light-emitting elements are electrically connected in series.

The first light-emitting elements and the second light-emitting elements may be electrically connected in series.

The first light-emitting elements and the second light-emitting elements may collectively include a sub-pixel.

The light-emitting element layer may further include a first electrode and a second electrode, wherein the pixel circuit layer further includes a first power line electrically connected to the first electrode, and a second power line electrically connected to the second electrode.

The first electrode and the first anode electrode may be integral.

The first light-emitting elements may further include a first bonding electrode adjacent to the first end, and electrically connected to the first anode electrode, wherein the second light-emitting elements further include a second bonding electrode adjacent to the first end, and electrically connected to the second anode electrode.

The first light-emitting elements and the second light-emitting elements may have a trapezoidal shape of cross-section.

The display device may further include a first organic layer covering the first anode electrode and the second anode electrode, wherein the first connection electrode is electrically connected to the second anode electrode through a contact portion passing through the first organic layer.

The display device may further include a second organic layer above the first organic layer, and including a substantially flat structure.

The first connection electrode might not overlap the second light-emitting elements in a plan view, and may include an electrical path between the first light-emitting elements and the second light-emitting elements.

The display device may further include an insulating layer that covers portions of side surfaces of the first light-emitting elements and the second light-emitting elements, covers the second end of the first light-emitting elements, and does not cover the second end of the second light-emitting elements.

The display device may further include a second connection electrode electrically connecting the second end of the second light-emitting elements and the second electrode.

According to one or more embodiments of the disclosure, a display device may include a base layer, a pixel circuit above the base layer, a first electrode, a first anode electrode electrically connected to the first electrode, a second anode electrode, and a second electrode above the base layer, and at a same layer as each other, light-emitting elements including a first semiconductor layer, a second semiconductor layer, an active layer between the first semiconductor layer and the second semiconductor layer, a first end adjacent the first semiconductor layer, and a second end adjacent the second semiconductor layer, the light-emitting elements including first light-emitting elements above the first anode electrode and including a first bonding electrode, and second light-emitting elements above the second anode electrode and including a second bonding electrode, a first connection electrode electrically connecting the first end of the first light-emitting elements and the second bonding electrode, and a second connection electrode electrically connecting the first end of the second light-emitting elements and the second electrode, wherein the first connection electrode and the second anode electrode are physically spaced apart from each other.

The display device may further include a first organic layer covering the first anode electrode and the second anode electrode, a second organic layer above the first organic layer, and covering portions of the second bonding electrode, and a third organic layer above the second organic layer, and covering a portion of the second light-emitting elements where the second bonding electrode is not located.

The first bonding electrode may be electrically connected to the first anode electrode, wherein the second bonding electrode is electrically connected to the second anode electrode, and wherein the first bonding electrode and the second bonding electrode have different shapes.

The second bonding electrode may surround a side of the second light-emitting elements in plan view.

According to one or more embodiments of the disclosure, a method of manufacturing a display device may include manufacturing a pixel circuit layer, and manufacturing a light-emitting element layer above the pixel circuit layer by patterning a first anode electrode and a second anode electrode on the pixel circuit layer, transferring first light-emitting elements on the first anode electrode, transferring second light-emitting elements on the second anode electrode, patterning a first organic layer defining a hole exposing the second anode electrode, and patterning a first connection electrode at least partially electrically connected to the first light-emitting elements, physically spaced apart from the second light-emitting elements, and provided in the hole to form a contact portion electrically connecting the first light-emitting elements and the second anode electrode.

Manufacturing the light-emitting element layer may further include forming an insulating layer covering the first connection electrode, and patterning a second organic layer covering the insulating layer above the first organic layer.

Manufacturing the light-emitting element layer may further include exposing at least a portion of the second light-emitting elements by removing another portion of the insulating layer overlapping the second light-emitting elements without removing a portion of the insulating layer overlapping the first light-emitting elements.

Manufacturing the light-emitting element layer may further include patterning a second connection electrode electrically connected to at least a portion of the second light-emitting elements exposed by the insulating layer.

### Advantageous Effects

According to one or more embodiments of the disclosure, a display device, and a method of manufacturing the display device capable of reducing or preventing the likelihood of malfunction of a pixel (for example, a light-emitting element), thereby reducing necessity of a repair process and improving process efficiency, may be provided.

### Description of Drawings

The above and other aspects of the disclosure will become more apparent by describing in further detail embodiments thereof with reference to the accompanying drawings, in which:
FIG. 1 is a schematic plan view illustrating a display device according to one or more embodiments;
FIG. 2 is a schematic cross-sectional view illustrating a display device according to one or more embodiments;
FIG. 3 is a schematic block diagram illustrating an electrical connection structure for a light-emitting element according to one or more embodiments;
FIGS. 4 and 5 are block diagrams schematically illustrating an electrical connection structure related to a light-emitting part according to one or more embodiments;
FIGS. 6 and 7 are schematic cross-sectional views illustrating a display device according to one or more embodiments; and
FIGS. 8 to 15 are schematic cross-sectional views for each process operation illustrating a method of manufacturing a display device according to one or more embodiments.

### Modes of the Invention

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

In the drawings, the relative sizes of elements, layers, and regions may be exaggerated for clarity and/or descriptive purposes. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "upper side," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the spirit and scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

The disclosure relates to a display device and a method of manufacturing the display device. Hereinafter, a display device and a method of manufacturing the display device according to one or more embodiments is described with reference to the accompanying drawings.

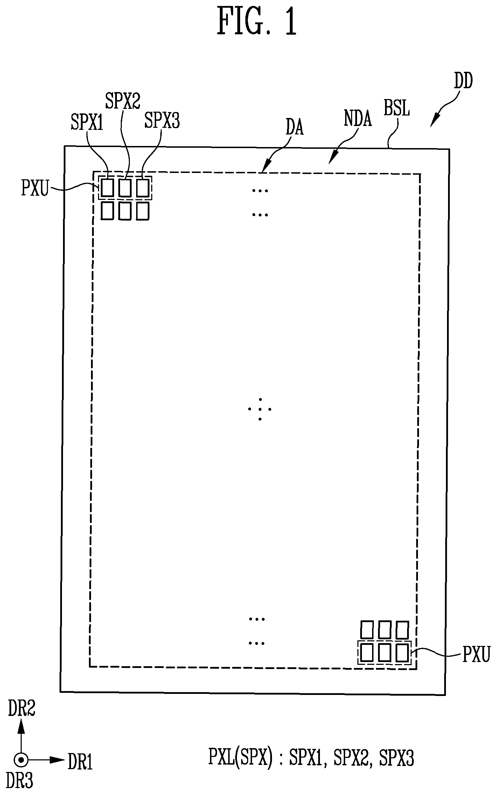

FIG. 1 is a schematic plan view illustrating a display device according to one or more embodiments.

Referring to FIG. 1, the display device DD may include a base layer BSL, and a pixel PXL located on the base layer BSL (as used herein, "located on" may mean "above"). In one or more embodiments, the display device DD may further include a driving circuit unit for driving the pixel PXL (for example, a scan driver and a data driver), lines, and pads.

The display device DD (or the base layer BSL) may include a display area DA and a non-display area NDA. The non-display area NDA may mean an area other than the display area DA. The non-display area NDA may surround at least a portion of the display area DA (e.g., in plan view).

The base layer BSL may form a base surface of the display device DD. The base layer BSL may be a rigid or flexible substrate or film. For example, the base layer BSL may include a glass material. Alternatively, the base layer BSL may include a silicon material. Alternatively, the base layer BSL may include polyimide. However, the disclosure is not limited thereto.

The display area DA may mean an area where the pixel PXL is located. The non-display area NDA may mean an area where the pixel PXL is not located. The driving circuit unit, the line, and the pads connected to the pixel PXL of the display area DA may be located in the non-display area NDA.

According to one or more embodiments, the pixel PXL (or sub-pixels SPX) may be arranged according to a stripe or PENTILETM arrangement structure (PENTILETM being a registered trademark of Samsung Display Co., Ltd., Republic of Korea), but are not limited thereto, and various embodiments may be applied to the disclosure.

According to one or more embodiments, the pixel PXL (or the sub-pixels SPX) may include a first sub-pixel SPX1, a second sub-pixel SPX2, and a third sub-pixel SPX3. Each of the first sub-pixel SPX1, the second sub-pixel SPX2, and the third sub-pixel SPX3 may be a sub-pixel. At least one of the first sub-pixel SPX1, the second sub-pixel SPX2, and the third sub-pixel SPX3 may form a pixel unit PXU configured to emit light of various colors.

Each of the first sub-pixel SPX1, the second sub-pixel SPX2, and the third sub-pixel SPX3 may emit light of a color.

For example, the first sub-pixel SPX1 may be a red pixel for emitting light of red (for example, first color), the second sub-pixel SPX2 may be a green pixel for emitting light of green (for example, second color), and the third sub-pixel SPX3 may be a blue pixel for emitting light of blue (for example, third color). The red pixel may provide light of a wavelength range of about 600 nm to about 750 nm. The green pixel may provide light of a wavelength range of about 480 nm to about 560 nm. The blue pixel may provide light of a wavelength range of about 370 nm to about 460 nm.

According to one or more embodiments, the number of second sub-pixels SPX2 may be greater than the number of first sub-pixels SPX1 and the number of third sub-pixels SPX3. However, the color, type, number, and/or the like of the first sub-pixel SPX1, the second sub-pixel SPX2, and the third sub-pixel SPX3 forming each pixel unit PXU are/is not limited to a specific example.

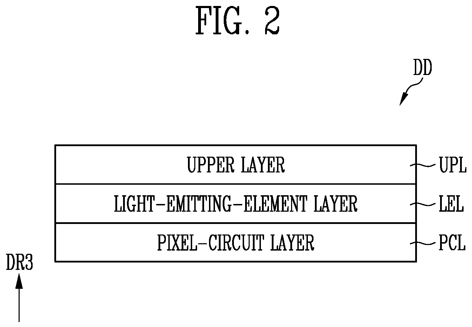

FIG. 2 is a schematic cross-sectional view illustrating a display device according to one or more embodiments.

Referring to FIG. 2, the display device DD may include a pixel circuit layer PCL, a light-emitting element layer LEL, and an upper layer UPL.

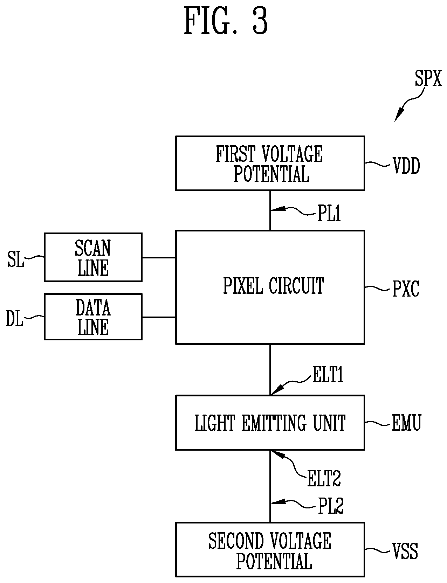

The pixel circuit layer PCL may include a base layer BSL and a pixel circuit PXC (e.g., see FIG. 3).

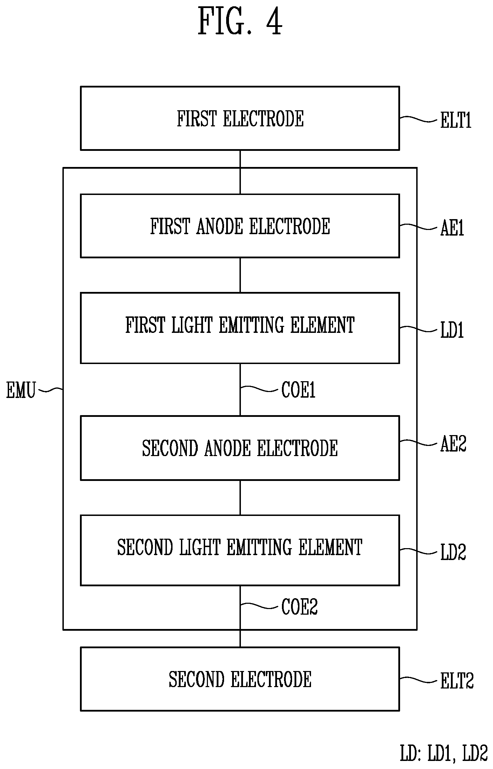

The base layer BSL may form a base on which the pixel circuit PXC is located. The pixel circuit PXC may be located on the base layer BSL and may be configured to drive a light-emitting element LD (e.g., see FIG. 4). The pixel circuit layer PCL may include conductive layers and insulating layers, and the conductive layers may form the pixel circuit PXC.

The light-emitting element layer LEL may be located on the pixel circuit layer PCL. The light-emitting element layer LEL may include the light-emitting element LD. The light-emitting element LD may include an inorganic light-emitting diode containing an inorganic material. For example, the light-emitting element LD may include a micro light-emitting diode (LED).

The upper layer UPL may be located on the light-emitting element layer LEL. The upper layer UPL may transmit light. According to one or more embodiments, the upper layer UPL may include a cover window. The upper layer UPL may include a color filter, and may include an upper substrate and the like. However, the disclosure is not limited to a specific example.

FIG. 3 is a schematic block diagram illustrating an electrical connection structure for a light-emitting element according to one or more embodiments. For example, FIG. 3 may illustrate an electrical connection structure including the pixel circuit PXC corresponding to each sub-pixel SPX. FIG. 3 shows the light-emitting part EMU including the light-emitting element LD. A description of the light-emitting part EMU in FIG. 3 may be similarly applied to the light-emitting element LD.

Referring to FIG. 3, the display device DD (for example, the sub-pixel SPX) may include the pixel circuit PXC configured to drive the light-emitting element LD of the light-emitting part EMU, a scan line SL, a data line DL, a first power line PL1, a second power line PL2, a first electrode ELT1, and a second electrode ELT2.

The pixel circuit PXC may include one or more circuit elements. For example, the pixel circuit PXC may include a driving transistor, a switching transistor, and a storage capacitor. However, the disclosure is not necessarily limited thereto.

The pixel circuit PXC may be electrically connected to the scan line SL and the data line DL. The scan line SL may supply a scan signal to the pixel circuit PXC, and according to one or more embodiments, may be electrically connected to a gate electrode of the switching transistor of the pixel circuit PXC. The light-emitting element LD may be configured to emit light corresponding to a data signal provided from the data line DL.

The pixel circuit PXC may be electrically connected to the first power line PL1 and the second power line PL2. For example, a first electrode ELT1 may be electrically connected to the pixel circuit PXC and the first power line PL1. A second electrode ELT2 may be electrically connected to the second power line PL2. The first power line PL1 and the second power line PL2 may be located on the base layer BSL, and may be included in the pixel circuit layer PCL according to one or more embodiments.

Power of the first power line PL1 and power of the second power line PL2 may have different potentials. For example, the power of the first power line PL1 may be high-potential pixel power from a first voltage potential VDD, and the power of the second power line PL2 may be low-potential pixel power from a second voltage potential VSS. A potential difference between the power of the first power line PL1 and the power of the second power line PL2 may be set to be equal to or greater than a threshold voltage of the light-emitting elements LD.

The first power line PL1 may be electrically connected to the pixel circuit PXC (for example, the driving transistor). The second power line PL2 may be electrically connected to a cathode electrode (for example, the second electrode ELT2) of the light-emitting element LD. According to one or more embodiments, the second power line PL2 may be electrically connected to the second electrode ELT2.

Each of the light-emitting elements LD included in the light-emitting part EMU may be connected in a forward direction between the first power line PL1 and the second power line PL2 to form each effective light source. These effective light sources may be gathered together to configure the light-emitting elements LD of the sub-pixel SPX.

The light-emitting elements LD may emit light with a luminance corresponding to a driving current supplied through the pixel circuit PXC. During each frame period, the pixel circuit PXC may supply the driving current corresponding to the data signal to the light-emitting element LD. The light-emitting element LD may emit light with a luminance corresponding to the current flowing therein.

Hereinafter, with reference to FIGS. 4 to 7, a display device DD including a light-emitting part EMU including a series/parallel structure is described, according to one or more embodiments. A content that may overlap the above-described content is briefly described or is not repeated.

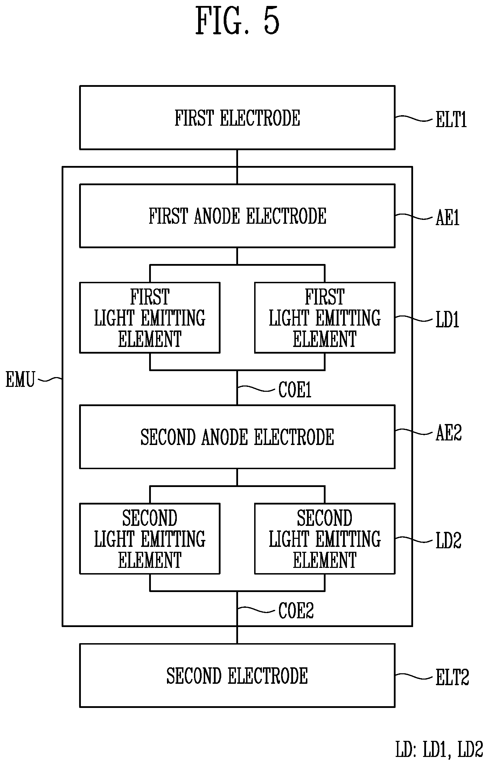

FIGS. 4 and 5 are block diagrams schematically illustrating an electrical connection structure related to a light-emitting part according to one or more embodiments.

Referring to FIGS. 4 and 5, the light-emitting part EMU may include a plurality of light-emitting elements LD electrically connected to each other in series. The light-emitting part EMU may include a plurality of light-emitting elements LD electrically connected to each other in a parallel structure. The light-emitting part EMU may include a plurality of light-emitting elements LD electrically connected to each other in a series/parallel structure.

The light-emitting part EMU may include a first anode electrode AE1, a second anode electrode AE2, a first connection electrode COE1, and a second connection electrode COE2 electrically connected to the plurality of light-emitting elements LD.

The plurality of light-emitting elements LD may be electrically connected between the first electrode ELT1 and the second electrode ELT2. The plurality of light-emitting elements LD may include first light-emitting elements LD1 and second light-emitting elements LD2.

For convenience of description, the disclosure is described based on one or more embodiments in which the plurality of light-emitting elements includes two parallel structures electrically connected to each other in series by including the first light-emitting elements LD1 and the second light-emitting elements LD2.

However, the number of parallel structures included in the plurality of light-emitting elements LD is not limited thereto. For example, third light-emitting elements and the like electrically connected to the second light-emitting elements LD may be further included.

The first anode electrode AE1 may be electrically connected to the first electrode ELT1. The first anode electrode AE1 may be an anode for the first light-emitting element LD1.

The first light-emitting elements LD1 may be electrically connected to each other in parallel. The first light-emitting elements LD1 may be electrically connected to the second light-emitting elements LD2 in series.

The first connection electrode COE1 may be electrically connected to the first light-emitting elements LD1. The first connection electrode COE1 may be electrically connected to the second anode electrode AE2.

The second anode electrode AE2 may be electrically connected to the first light-emitting elements LD1. The second anode electrode AE2 may be an anode for the second light-emitting element LD2.

The second light-emitting elements LD2 may be electrically connected to each other in parallel. The second light-emitting elements LD2 may be electrically connected to the first light-emitting elements LD1 in series.

The second connection electrode COE2 may be electrically connected to the second light-emitting elements LD2. The second connection electrode COE2 may be electrically connected to the second electrode ELT2.

Accordingly, the light-emitting part EMU may form a sub-pixel SPX, and an electrical signal, which is supplied by the pixel circuit PXC, may be supplied to the first and second light-emitting elements LD1 and LD2. In addition, due to the series/parallel structure according to one or more embodiments, even though the first light-emitting elements LD1 do not normally operate, the second light-emitting elements LD2 may normally operate, and even though the second light-emitting elements LD2 do not normally operate, the first light-emitting elements LD1 may normally operate.

According to one or more embodiments, the likelihood of malfunction of the light-emitting elements LD may be reduced or prevented, and thus a risk of an abnormal operation of the pixel may be reduced. For example, in a sub-pixel SPX, in a case where all of the plurality of light-emitting elements LD are located on a single anode, when a short defect occurs in one of the light-emitting elements LD, it may be difficult for all light-emitting elements LD on a corresponding anode to emit normally light.

However, according to one or more embodiments, as described above, the first anode electrode AE1 and the second anode electrode AE2 may be provided separately. The first light-emitting elements LD1 and the second light-emitting elements LD2 may be provided on the first anode electrode AE1 and the second anode electrode AE2, respectively. Thus, the likelihood of malfunction of the sub-pixel SPX (for example, the light-emitting element LD) may be reduced or prevented.

For example, when malfunction of the sub-pixel SPX occurs, a separate repair process may be performed, a process operation may become complicated, and thus a process cost may be increased. However, a risk of malfunction of the sub-pixel SPX may be reduced, and thus a process cost may be reduced.

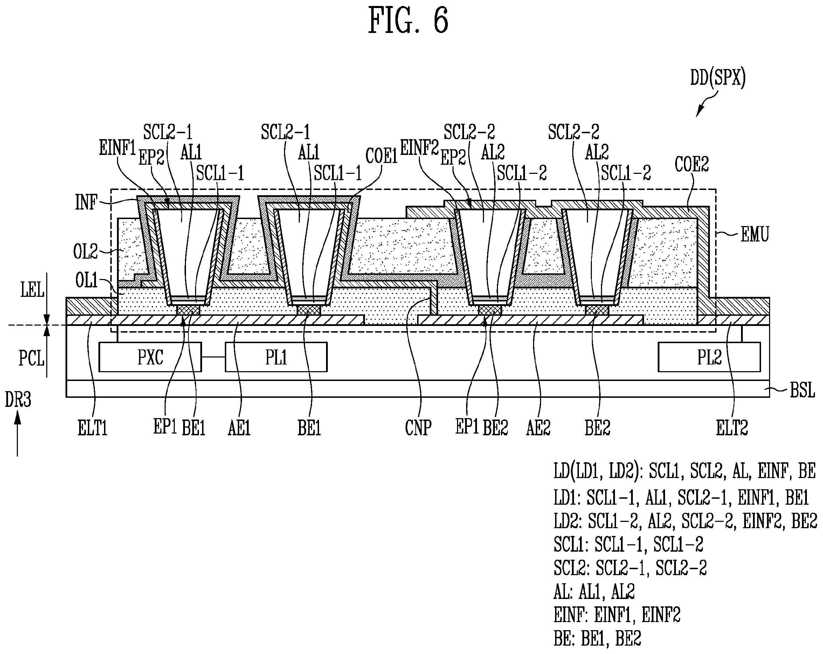

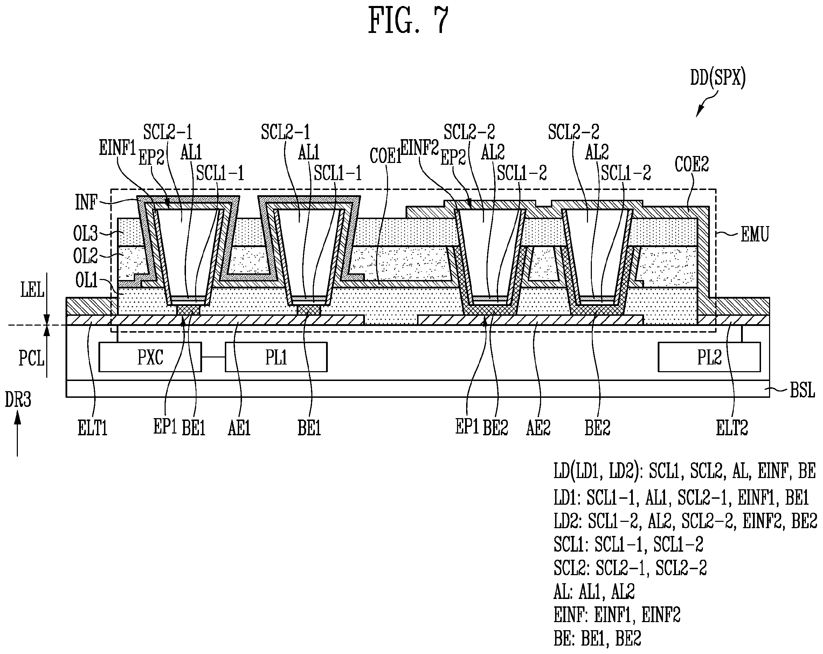

Next, with reference to FIGS. 6 and 7, a cross-sectional structure of a display device DD according to one or more embodiments is described.

FIGS. 6 and 7 are schematic cross-sectional views illustrating a display device according to one or more embodiments. A content that may overlap the content described above is briefly described or is not repeated.

First, with reference to FIG. 6, a display device DD according to one or more embodiments is described.

According to one or more embodiments, the pixel circuit layer PCL may include the base layer BSL, the pixel circuit PXC, the first power line PL1, and the second power line PL2 located on the base layer BSL.

The first power line PL1 may be electrically connected to the pixel circuit PXC and may supply power of a first voltage potential VDD to the pixel circuit PXC. The second power line PL2 may be spaced apart from the first power line PL1, and may supply power of a second voltage potential VSS to the second electrode ELT2.

The light-emitting element layer LEL may include the first electrode ELT1, the second electrode ELT2, and the light-emitting part EMU electrically connected between the first and second electrodes ELT1 and ELT2. The light-emitting element layer LEL (or the light-emitting part EMU) may include the first anode electrode AE1, the second anode electrode AE2, the first connection electrode COE1, and the second connection electrode COE2. The light-emitting element layer LEL may include a first organic layer OL1, an insulating layer INF, and a second organic layer OL2.

The first electrode ELT1 and the second electrode ELT2 may be located on the pixel circuit layer PCL. According to one or more embodiments, the first electrode ELT1 and the second electrode ELT2 may be patterned in the same process, and may include the same material. For example, the first electrode ELT1 and the second electrode ELT2 may be formed in a same deposition process.

The first electrode ELT1 and the second electrode ELT2 may include a conductive material, and may be electrically connected to another layer in the pixel circuit layer PCL through a contact structure. For example, the first electrode ELT1 may be electrically connected to the pixel circuit PXC, and the second electrode ELT2 may be electrically connected to the second power line PL2.

The first anode electrode AE1 and the second anode electrode AE2 may be located on the pixel circuit layer PCL. According to one or more embodiments, the first anode electrode AE1 and the second anode electrode AE2 may be patterned in a same process, and may include a same material. For example, the first anode electrode AE1 and the second anode electrode AE2 may be formed in the same deposition process.

The first and second electrodes ELT1 and ELT2 and the first and second anode electrodes AE1 and AE2 may be patterned in a same process, and may include a same material.

According to one or more embodiments, the first anode electrode AE1 may be formed integrally with the first electrode ELT1. For example, a portion of an electrode layer patterned on the pixel circuit layer PCL may be the first electrode ELT1, and another portion may be the first anode electrode AE1.

The first light-emitting elements LD1 may be located on the first anode electrode AE1. The first light-emitting elements LD1 may contact the first anode electrode AE1. For example, the first light-emitting elements LD1 may be located on the same first anode electrode AE1, and may emit light based on the same electrical signal.

The second light-emitting elements LD2 may be located on the second anode electrode AE2. The second light-emitting elements LD2 may contact the second anode electrode AE2. For example, the second light-emitting elements LD2 may be located on the same second anode electrode AE2, and may emit light based on the same electrical signal.

According to one or more embodiments, the light-emitting element LD may include a first semiconductor layer SCL1, a second semiconductor layer SCL2, an active layer AL, an element-insulating layer EINF, and a bonding electrode BE. The light-emitting element LD may include a first end EP1 to which the first semiconductor layer SCL1 is adjacent, and a second end EP2 to which the second semiconductor layer SCL2 is adjacent.

The light-emitting element LD may be manufactured based on an epitaxial process, an etching process, and the like performed on a separate wafer, and may be transferred on the pixel circuit layer PCL by various methods.

The light-emitting elements LD may be aligned in a vertical direction on the first and second anode electrodes AE1 and AE2. For example, a direction from the first end EP1 to the second end EP2 may correspond to a thickness direction of the base layer BSL.

The light-emitting elements LD may have various shapes. For example, the light-emitting elements LD may have a trapezoidal shape of cross-section. A cross-sectional area at the first end EP1 of the light-emitting elements LD may be less than a cross-sectional area at the second end EP2. However, the disclosure is not limited to a specific example. According to one or more embodiments, the light-emitting elements LD may have a pillar shape extending in a direction.

The light-emitting element LD may have various sizes. For example, the light-emitting element LD may have a size of nanoscale to microscale. However, the disclosure is not limited thereto.

The first semiconductor layer SCL1 may include a semiconductor of a first conductivity type. The first semiconductor layer SCL1 may be located on the active layer AL, and may include a semiconductor layer of a type different from that of the second semiconductor layer SCL2. For example, the first semiconductor layer SCL1 may include a P-type semiconductor layer. For example, the first semiconductor layer SCL1 may include one or more semiconductor materials selected from a group of InAlGaN, GaN, AlGaN, InGaN, AlN, or InN, and may include a P-type semiconductor layer doped with a first conductivity type dopant, such as Ga, B, or Mg. However, the disclosure is not limited to the example described above. The first semiconductor layer SCL1 may include various materials.

The first semiconductor layer SCL1 may be adjacent to the bonding electrode BE, and may face the first anode electrode AE1.

According to one or more embodiments, the first semiconductor layer SCL1 may include a (1-1)-th semiconductor layer SCL1-1 included in the first light-emitting elements LD1, and a (1-2)-th semiconductor layer SCL1-2 included in the second light-emitting elements LD2.

The active layer AL may be located between the second semiconductor layer SCL2 and the first semiconductor layer SCL1. The active layer AL may include a single-quantum well or multi-quantum well structure. A position of the active layer AL is not limited to a specific example, and may be variously changed according to a type of the light-emitting element LD.

A clad layer doped with a conductive dopant may be formed on one side and/or another side of the active layer. For example, the clad layer may include one or more of AlGaN or InAlGaN. However, the disclosure is not limited to the example described above.

According to one or more embodiments, the active layer AL may include a first active layer AL1 included in the first light-emitting elements LD1, and a second active layer AL2 included in the second light-emitting elements LD2.

The second semiconductor layer SCL2 may include a semiconductor of a second conductivity type. The second semiconductor layer SCL2 may be located on the active layer AL, and may include a semiconductor layer of a type that is different from that of the first semiconductor layer SCL1. For example, the second semiconductor layer SCL2 may include an N-type semiconductor layer. For example, the second semiconductor layer SCL2 may include one or more selected from a group of InAlGaN, GaN, AlGaN, InGaN, AlN, or InN, and may include an N-type semiconductor layer doped with a second conductivity type dopant, such as Si, Ge, or Sn. However, the disclosure is not limited to the example described above. The second semiconductor layer SCL2 may include various materials.

The second semiconductor layer SCL2 may be adjacent to the first connection electrode COE1 or the second connection electrode COE2, and may face the first connection electrode COE1 or the second connection electrode COE2.

According to one or more embodiments, the second semiconductor layer SCL2 may include a (2-1)-th semiconductor layer SCL2-1 included in the first light-emitting elements LD1, and a (2-2)-th semiconductor layer SCL2-2 included in the second light-emitting elements LD2.

The light-emitting element LD may be electrically connected to the first and second anode electrodes AE1 and AE2 through the first end EP1 (for example, the bonding electrode BE). The light-emitting element LD may be electrically connected to the first connection electrode COE1 or the second connection electrode COE2 through the second end EP2.

When a voltage equal to or greater than the threshold voltage is applied to the first end EP1 and the second end EP2 of the light-emitting element LD, an electron-hole pair may recombine with each other in the active layer AL, and the light-emitting element LD may emit light. By controlling light emission of the light-emitting element LD using such a principle, the light-emitting element LD may be used as a light source in various devices.

The bonding electrode BE may be patterned to be located on the first semiconductor layer SCL1 when manufacturing the light-emitting elements LD. The bonding electrode BE may be a layer for transferring the light-emitting elements LD on the first and second anode electrodes AE1 and AE2.

For example, the light-emitting elements LD may be located on the first and second anode electrodes AE1 and AE2 such that the bonding electrode BE faces the first and second anode electrodes AE1 and AE2, heat may be applied to the bonding electrode BE, and thus the light-emitting elements LD and the first and second anode electrodes AE1 and AE2 may be combined with each other.

The bonding electrode BE may include various conductive materials. The bonding electrode BE may include a first bonding electrode BE1 included in the first light-emitting elements LD1, and a second bonding electrode BE2 included in the second light-emitting elements LD2.

The element-insulating layer EINF may be located on an outer surface of the first semiconductor layer SCL1, the active layer AL, and the second semiconductor layer SCL2. The element-insulating layer EINF may surround the outer surface of the active layer AL, and may further surround a portion of each of the first semiconductor layer SCL1 and the second semiconductor layer SCL2. The element-insulating layer EINF may have a single-layer or multi-layer structure. The element-insulating layer EINF may expose the first end EP1 and the second end EP2 of the light-emitting element LD having different respective polarities.

According to one or more embodiments, the element-insulating layer EINF may include one or more of a group of silicon oxide (SiOx), silicon nitride (SiNx), silicon oxynitride (SiOxNy), aluminum oxide (AlxOy), or titanium oxide (TiOx). However, the disclosure is not limited to the example described above.

The element-insulating layer EINF may include a first element-insulating layer EINF1 included in the first light-emitting elements LD1, and a second element-insulating layer EINF2 included in the second light-emitting elements LD2.

The first organic layer OL1 may be located on the pixel circuit layer PCL. The first organic layer OL1 may cover the first and second anode electrodes AE1 and AE2. The first organic layer OL1 may fill a space between the light-emitting elements LD. The first organic layer OL1 may surround an area where a contact portion CNP and the first and second light-emitting elements LD1 and LD2 are located.

The first organic layer OL1 may be a first via layer. The first organic layer OL1 may include an organic material. For example, the first organic layer OL1 may include one or more of a group of acrylic resin, epoxy resin, phenol resin, polyamide resin, or polyimide resin. However, the disclosure is not limited thereto.

The first organic layer OL1 may electrically separate the first anode electrode AE1 and the first connection electrode COE1. Accordingly, the second end EP2 of the first light-emitting elements LD1 may be electrically connected to the second anode electrode AE2 through the first connection electrode COE1 and the contact portion CNP.

The contact portion CNP may be formed in the first organic layer OL1. The contact portion CNP may be manufactured in the same process as the first connection electrode COE1, may pass through the first organic layer OL1, and may electrically connect the first connection electrode COE1 and the second anode electrode AE2.

The first connection electrode COE1 may be located on the first light-emitting elements LD1 and the first organic layer OL1. The first connection electrode COE1 may be electrically connected to the second end EP2 of the first light-emitting elements LD1, and may not overlap the second light-emitting elements LD2 in a plan view to be electrically separated from the second light-emitting elements LD2. The first connection electrode COE1 may be electrically connected to the second anode electrode AE2 through the contact portion CNP.

The first connection electrode COE1 may be patterned after the light-emitting elements LD are transferred on the first and second anode electrodes AE1 and AE2. The first connection electrode COE1 may be an intermediate electrode for electrically connecting the first and second light-emitting elements LD1 and LD2 to each other in series.

The first connection electrode COE1 may include a conductive material. According to one or more embodiments, the first connection electrode COE1 may include a transparent conductive material. For example, the first connection electrode COE1 may include one or more of a group of silver nanowire (AgNW), indium tin oxide (ITO), indium zinc oxide (IZO), indium gallium zinc oxide (IGZO), antimony zinc oxide (AZO), indium tin zinc oxide (ITZO), zinc oxide (ZnO), tin oxide (SnO2), carbon nano tube, or graphene.

The insulating layer INF may be located on the first connection electrode COE1, the first organic layer OL1, and the first and second light-emitting elements LD1 and LD2. The insulating layer INF may cover the first connection electrode COE1 and cover each side surface of the second light-emitting elements LD2.

The insulating layer INF may include an inorganic material. For example, the insulating layer INF may include one or more of a group of silicon oxide (SiOx), silicon nitride (SiNx), silicon oxynitride (SiOxNy), aluminum oxide (AlxOy, or titanium oxide (TiOx). However, the disclosure is not limited to the example described above.

The insulating layer INF may be a protective layer for the first connection electrode COE1. For example, the insulating layer INF may cover an upper surface of the first connection electrode COE1, and during an etching process for patterning the second connection electrode COE2, a risk that the first connection electrode COE1 may be removed by an etchant or the like may be reduced.

The second organic layer OL2 may be located on the pixel circuit layer PCL. The second organic layer OL2 may cover the insulating layer INF. The second organic layer OL2 may fill a space between the light-emitting elements LD.

The second organic layer OL2 may be a planarization layer. The second organic layer OL2 may include an organic material. For example, the second organic layer OL2 may include one or more of a group of acrylic resin, epoxy resin, phenol resin, polyamide resin, or polyimide resin. However, the disclosure is not limited thereto.

The second organic layer OL2 may expose the second ends EP2 of the second light-emitting elements LD2. The second organic layer OL2 may reduce a step between configurations between the second organic layer OL2 and the pixel circuit layer PCL, and thus the second connection electrode COE2 may be appropriately patterned.

The second connection electrode COE2 may be located on the second light-emitting elements LD2 and the second organic layer OL2. The second connection electrode COE2 may be electrically connected to the second end EP2 of the second light-emitting elements LD2. According to one or more embodiments, the second connection electrode COE2 may not overlap the first light-emitting elements LD1 in a plan view. The second connection electrode COE2 may be electrically connected to the second electrode ELT2.

The second connection electrode COE2 may be patterned after the second organic layer OL2 is manufactured. The second connection electrode COE2 may be an intermediate electrode for electrically connecting the first and second light-emitting elements LD1 and LD2 to the second electrode ELT2 in series.

The second connection electrode COE2 may include a conductive material. According to one or more embodiments, the second connection electrode COE2 may include a transparent conductive material. For example, the second connection electrode COE2 may include one or more of a group of silver nanowire (AgNW), indium tin oxide (ITO), indium zinc oxide (IZO), indium gallium zinc oxide (IGZO), antimony zinc oxide (AZO), indium tin zinc oxide (ITZO), zinc oxide (ZnO), tin oxide (SnO2), carbon nano tube, or graphene.

According to one or more embodiments, the light-emitting part EMU may form a sub-pixel SPX. In addition, an electrical structure in which the light-emitting elements LD electrically connected in series/parallel may be implemented as a structure in which the light-emitting elements LD are aligned in a vertical direction. In this case, a defect risk of the sub-pixels SPX may be significantly reduced.

Next, with reference to FIG. 7, a display device DD according to one or more other embodiments is described. FIG. 7 shows the display device DD according to the one or more other embodiments.

The display device DD according to the one or more other embodiments is different from the display device DD according to the one or more embodiments described above, in that the first connection electrode COE1 is electrically connected to the second light-emitting elements LD2 through the second bonding electrode BE2.

According to one or more embodiments, the first bonding electrode BE1 and the second bonding electrode BE2 may have different shapes. For example, the first bonding electrode BE1 may have a generally flat shape, and the second bonding electrode BE2 may have a shape corresponding to a shape of the second element-insulating layer EINF2 of the corresponding second light-emitting element LD2. The second bonding electrode BE2 may surround a side of the second light-emitting element LD2 (e.g., in plan view), and may be formed to correspond to a side shape of the second light-emitting element LD2. For example, at least a portion of the second bonding electrode BE2 may be electrically connected to the (1-2)-th semiconductor layer SCL1-2, and another portion of the second bonding electrode BE2 may be located on the second element-insulating layer EINF2.

According to one or more embodiments, the first connection electrode COE1 may be electrically connected to the second bonding electrode BE2. For example, the first connection electrode COE1 may be physically spaced apart from the second anode electrode AE2, and may be in contact with the second bonding electrode BE2. Accordingly, an electrical signal provided from the pixel circuit PXC may be provided to each of the second light-emitting elements LD2 through the first connection electrode COE1 and the second bonding electrode BE2.

According to one or more embodiments, the light-emitting element layer LEL may further include a third organic layer OL3. The third organic layer OL3 may be located on the second organic layer OL2, and may include one or more of the organic materials described above with reference to the second organic layer OL2. The third organic layer OL3 may cover a side of the second light-emitting elements LD2 where the second bonding electrodes BE2 are not located.

The third organic layer OL3 may electrically separate the first connection electrode COE1 and the second bonding electrode BE2 from the second connection electrode COE2. For example, at least a portion of the third organic layer OL3 may be located between the first connection electrode COE1/the second bonding electrode BE2 and the second connection electrode COE2.

Because the first connection electrode COE1 is electrically connected to the second bonding electrode BE2 other than the first anode electrode AE1, there may be no need for a partial area of the first anode electrode AE1 to be electrically connected to the first connection electrode COE1. In this case, because the area of the first anode electrode AE1 may be utilized efficiently, process convenience may be improved, and an where the second light-emitting elements LD2 may be located may be further widely secured.

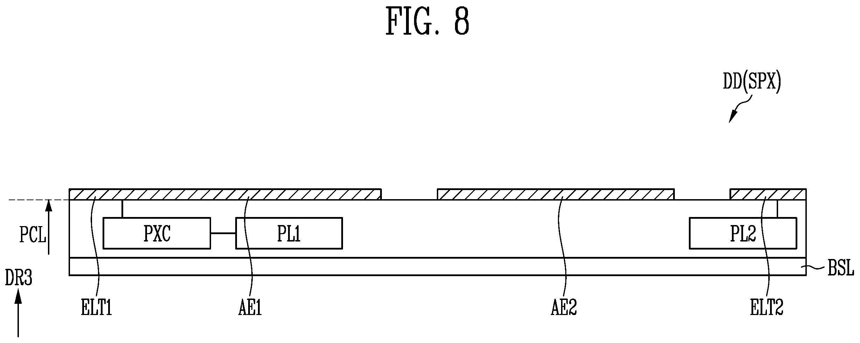

Next, with reference to FIGS. 8 to 15, a method of manufacturing a display device DD according to one or more embodiments is described. Content that may overlap the content described above is briefly described or is not repeated.

FIGS. 8 to 15 are schematic cross-sectional views for each process operation illustrating a method of manufacturing a display device according to one or more embodiments. For convenience of description, FIGS. 8 to 15 are described based on the one or more embodiments described above with reference to FIG. 6.

Referring to FIG. 8, the pixel circuit layer PCL may be manufactured, and the first electrode ELT1, the second electrode ELT2, the first anode electrode AE1, and the second anode electrode AE2 may be patterned on the pixel circuit layer PCL.

According to one or more embodiments, the pixel circuit layer PCL may be manufactured by patterning a conductive layer and an insulating layer on the base layer BSL. According to one or more embodiments, the conductive layer or the insulating layer on the base layer BSL may be formed based on a typical process for manufacturing a semiconductor device. For example, the conductive layer or the insulating layer on the base layer BSL may be formed by a photolithography process, etched by various methods (wet etching, dry etching, and the like), and deposited by various methods (sputtering, chemical vapor deposition method, and the like). The disclosure is not necessarily limited to a specific example.

In the present operation, the first and second power lines PL1 and PL2 and the pixel circuit PXC may be patterned on the base layer BSL.

In the present operation, the first and second electrodes ELT1 and ELT2 and the first and second anode electrodes AE1 and AE2 may be patterned. As described above, according to one or more embodiments, the first anode electrode AE1 and the first electrode ELT1 may be integrally formed. Accordingly, the first and second anode electrodes AE1 and AE2 spaced apart from each other may be provided.

At the present operation, the first electrode ELT1 may be electrically connected to the pixel circuit PXC1, and the second electrode ELT2 may be electrically connected to the second power line PL2.

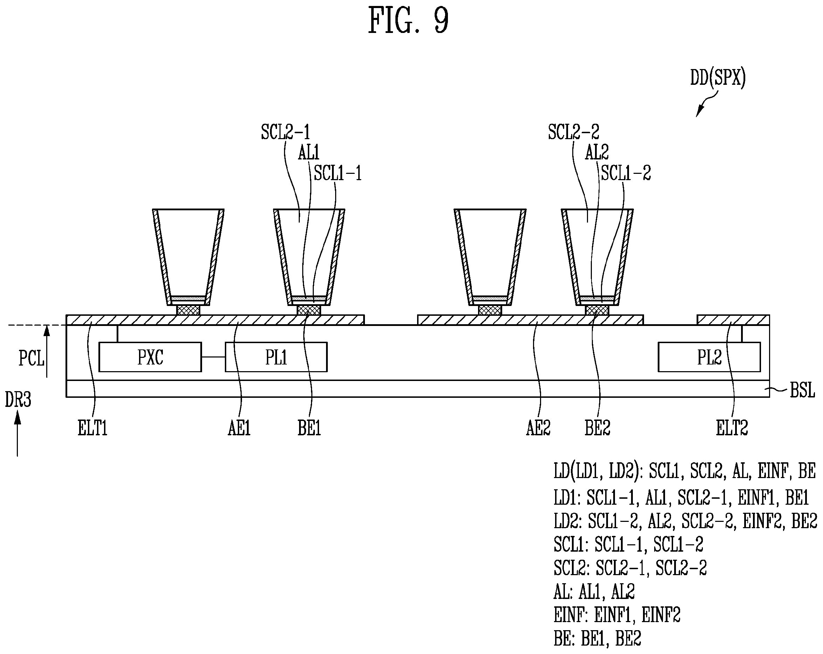

Referring to FIG. 9, the light-emitting elements LD may be transferred on the pixel circuit layer PCL.

In the present operation, the light-emitting elements LD may be transferred on the pixel circuit layer PCL so that the first end EP1 faces the first and second anode electrodes AE1 and AE2. For example, the first and second bonding electrodes BE1 and BE2 may be located on the first and second anode electrodes AE1 and AE2, respectively, a thermal melting process or the like may be performed, and thus the first and second bonding electrodes BE1 and BE2 may be combined with the first and second anode electrodes AE1 and AE2, respectively. However, the disclosure is not limited thereto, and the light-emitting elements LD may be transferred by various methods.

In the present operation, the first light-emitting elements LD1 may be electrically connected to the first anode electrode AE1, and the second light-emitting elements LD2 may be electrically connected to the second anode electrode AE2.

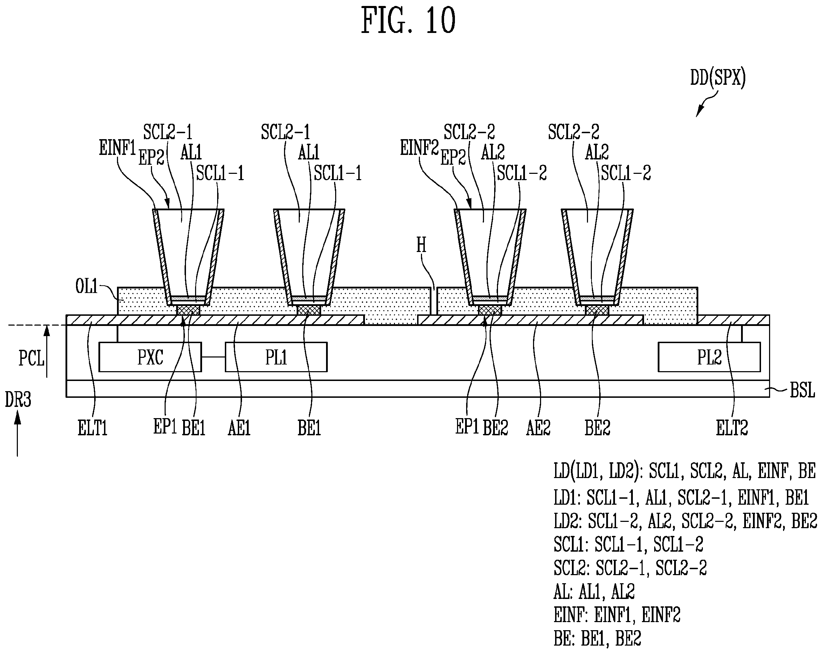

Referring to FIG. 10, the first organic layer OL1 may be patterned on the pixel circuit layer PCL.

At the present stage, the first organic layer OL1 may cover a side surface (e.g., a portion of a side surface) of each of the first and second light-emitting elements LD1 and LD2, and may fill the space between the light-emitting elements LD. The first organic layer OL1 may cover a side surface of the first and second bonding electrodes BE1 and BE2.

In the present operation, the first organic layer OL1 may have a hole H exposing the second anode electrode AE2 formed therein.

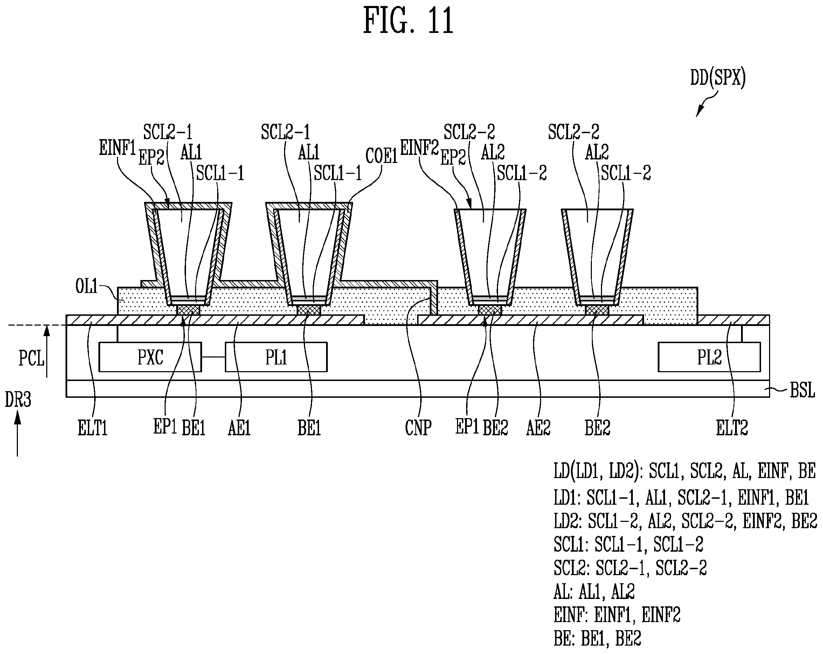

Referring to FIG. 11, the first connection electrode COE1 may be patterned.

In the present operation, the first connection electrode COE1 may be electrically connected to the second ends EP2 of the first light-emitting elements LD1. In addition, a conductive material formed (for example, deposited) in the same process as the first connection electrode COE1 may be provided in the hole H to form the contact portion CNP. Accordingly, in the present operation, the first light-emitting elements LD1 may be electrically connected to the second anode electrode AE2 through the first connection electrode COE1 and the contact portion CNP.

In the present operation, the first connection electrode COE1 may be patterned so as not to overlap the second light-emitting elements LD2 in a plan view.

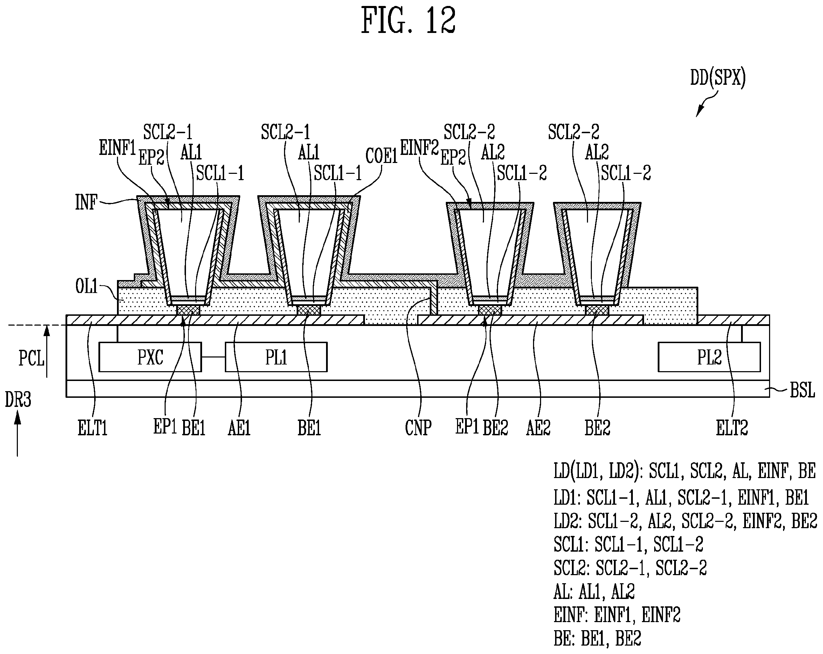

Referring to FIG. 12, the insulating layer INF may be patterned.

In the present operation, the insulating layer INF may cover the first connection electrode COE1. In addition, the insulating layer INF may cover at least a portion of the second light-emitting elements LD2. Accordingly, the insulating layer INF may appropriately passivate the first connection electrode COE1, and a risk that the first connection electrode COE1 may be damaged may be reduced.

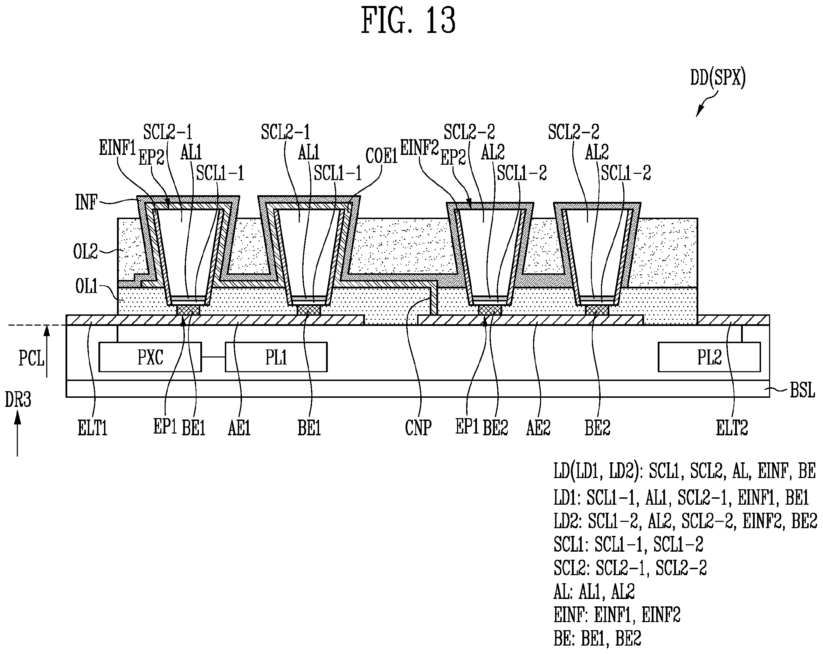

Referring to FIG. 13, the second organic layer OL2 may be patterned on the first organic layer OL1 and the insulating layer INF.

In the present operation, the second organic layer OL2 may cover a side surface of each of the first and second light-emitting elements LD1 and LD2, and may fill the space between the light-emitting elements LD. Accordingly, the second organic layer OL2 may alleviate a step formed due to other configurations.

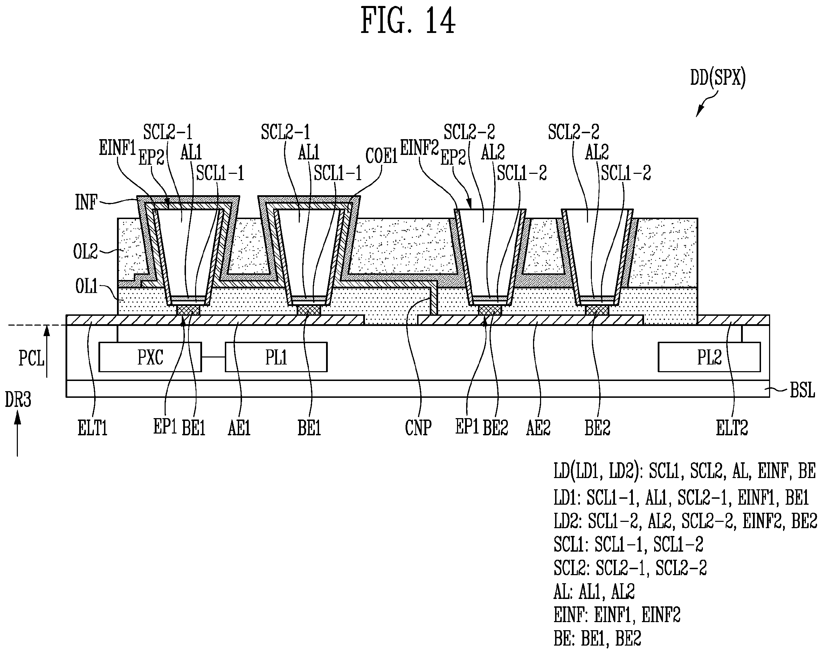

Referring to FIG. 14, at least a portion of the insulating layer INF may be etched, and thus the second ends EP2 of the second light-emitting elements LD2 may be exposed.

In the present operation, a portion of the insulating layer INF on the first light-emitting elements LD1 may not be removed, while another portion(s) of the insulating layer INF on the second light-emitting elements LD2 may be removed.

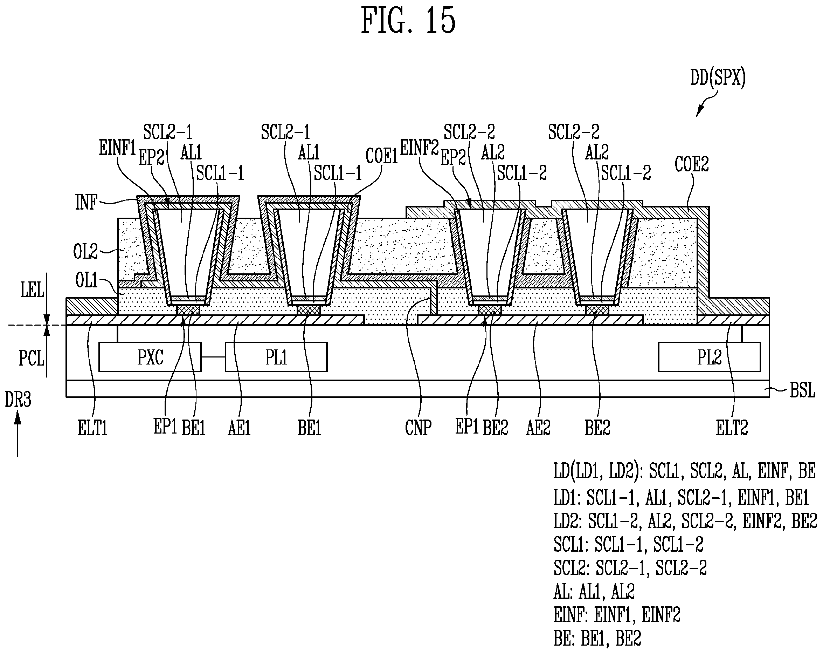

Referring to FIG. 15, the second connection electrode COE2 may be patterned.

In the present operation, the second connection electrode COE2 may be electrically connected to the second ends EP2 of the second light-emitting elements LD2. In addition, the second connection electrode COE2 may be electrically connected to the second electrode ELT2. Accordingly, in the present operation, a series/parallel electrical connection structure between the first and second light-emitting elements LD1 and LD2 may be defined between the first and second electrodes ELT1 and ELT2.

Thereafter, according to one or more embodiments, forming the upper layer UPL on the light-emitting element layer LEL may be further performed, and thus the display device DD according to one or more embodiments may be prepared.

As described above, although the disclosure has been described with reference to the one or more embodiments above, those skilled in the art or those having a common knowledge in the art will understand that the disclosure may be variously modified and changed without departing from the spirit and technical area of the disclosure described in the claims which will be described later.

Therefore, the technical scope of the disclosure should not be limited to the contents described in the detailed description of the specification, but should be defined by the claims, with functional equivalents thereof to be included therein.

## Claims

1. A display device comprising:
a pixel circuit layer comprising a pixel circuit above a base layer; and
a light-emitting element layer above the pixel circuit layer, and comprising:
a light-emitting part comprising a first anode electrode;
a first connection electrode;
a second anode electrode;
first light-emitting elements above the first anode electrode; and
second light-emitting elements above the second anode electrode,
wherein the first light-emitting elements and the second light-emitting elements comprise a first semiconductor layer, a second semiconductor layer, an active layer between the first semiconductor layer and the second semiconductor layer, a first end to which the first semiconductor layer is adjacent, and a second end to which the second semiconductor layer is adjacent, and
wherein the first connection electrode electrically connects the first end of the first light-emitting elements and the second anode electrode such that the first light-emitting elements and the second light-emitting elements are electrically connected in series.

2. The display device according to claim 1, wherein the first light-emitting elements and the second light-emitting elements are electrically connected in series.

3. The display device according to claim 1, wherein the first light-emitting elements and the second light-emitting elements collectively comprise a sub-pixel.

4. The display device according to claim 1, wherein the light-emitting element layer further comprises a first electrode and a second electrode,
wherein the pixel circuit layer further comprises a first power line electrically connected to the first electrode, and a second power line electrically connected to the second electrode.

5. The display device according to claim 4, wherein the first electrode and the first anode electrode are integral.

6. The display device according to claim 1, wherein the first light-emitting elements further comprise a first bonding electrode adjacent to the first end, and electrically connected to the first anode electrode,
wherein the second light-emitting elements further comprise a second bonding electrode adjacent to the first end, and electrically connected to the second anode electrode.

7. The display device according to claim 1, wherein the first light-emitting elements and the second light-emitting elements have a trapezoidal shape of cross-section.

8. The display device according to claim 1, further comprising a first organic layer covering the first anode electrode and the second anode electrode,
wherein the first connection electrode is electrically connected to the second anode electrode through a contact portion passing through the first organic layer.

9. The display device according to claim 8, further comprising a second organic layer above the first organic layer, and comprising a substantially flat structure.

10. The display device according to claim 1, wherein the first connection electrode does not overlap the second light-emitting elements in a plan view, and comprises an electrical path between the first light-emitting elements and the second light-emitting elements.

11. The display device according to claim 1, further comprising an insulating layer that covers portions of side surfaces of the first light-emitting elements and the second light-emitting elements, covers the second end of the first light-emitting elements, and does not cover the second end of the second light-emitting elements.

12. The display device according to claim 4, further comprising a second connection electrode electrically connecting the second end of the second light-emitting elements and the second electrode.

13. A display device comprising:
a base layer;
a pixel circuit above the base layer;
a first electrode, a first anode electrode electrically connected to the first electrode, a second anode electrode, and a second electrode above the base layer, and at a same layer as each other;
light-emitting elements comprising a first semiconductor layer, a second semiconductor layer, an active layer between the first semiconductor layer and the second semiconductor layer, a first end adjacent the first semiconductor layer, and a second end adjacent the second semiconductor layer, the light-emitting elements comprising first light-emitting elements above the first anode electrode and comprising a first bonding electrode, and second light-emitting elements above the second anode electrode and comprising a second bonding electrode;
a first connection electrode electrically connecting the first end of the first light-emitting elements and the second bonding electrode; and
a second connection electrode electrically connecting the first end of the second light-emitting elements and the second electrode,
wherein the first connection electrode and the second anode electrode are physically spaced apart from each other.

14. The display device according to claim 13, further comprising:
a first organic layer covering the first anode electrode and the second anode electrode;
a second organic layer above the first organic layer, and covering portions of the second bonding electrode; and
a third organic layer above the second organic layer, and covering a portion of the second light-emitting elements where the second bonding electrode is not located.

15. The display device according to claim 13, wherein the first bonding electrode is electrically connected to the first anode electrode,
wherein the second bonding electrode is electrically connected to the second anode electrode, and
wherein the first bonding electrode and the second bonding electrode have different shapes.

16. The display device according to claim 15, wherein the second bonding electrode surrounds a side of the second light-emitting elements in plan view.

17. A method of manufacturing a display device, the method comprising:
manufacturing a pixel circuit layer; and
manufacturing a light-emitting element layer above the pixel circuit layer by:
patterning a first anode electrode and a second anode electrode on the pixel circuit layer;
transferring first light-emitting elements on the first anode electrode;
transferring second light-emitting elements on the second anode electrode;
patterning a first organic layer defining a hole exposing the second anode electrode; and
patterning a first connection electrode at least partially electrically connected to the first light-emitting elements, physically spaced apart from the second light-emitting elements, and provided in the hole to form a contact portion electrically connecting the first light-emitting elements and the second anode electrode.

18. The method according to claim 17, wherein manufacturing the light-emitting element layer further comprises:
forming an insulating layer covering the first connection electrode; and
patterning a second organic layer covering the insulating layer above the first organic layer.

19. The method according to claim 18, wherein manufacturing the light-emitting element layer further comprises exposing at least a portion of the second light-emitting elements by removing another portion of the insulating layer overlapping the second light-emitting elements without removing a portion of the insulating layer overlapping the first light-emitting elements.

20. The method according to claim 19, wherein manufacturing the light-emitting element layer further comprises patterning a second connection electrode electrically connected to at least a portion of the second light-emitting elements exposed by the insulating layer.
